# EUROPEAN PATENT SPECIFICATION

(11) **EP 3 665 513 B1**
(45) Date of publication and mention of the grant of the patent: **25.03.2026**
(21) Application number: 18844089.5
(22) Date of filing: 08.08.2018
(51) Int. Cl.: G02B 1/10, G02B 5/08, G03F 1/24, G02B 5/20, G02B 5/28

(54) **MATERIALS, COMPONENT, AND METHODS FOR USE WITH EXTREME ULTRAVIOLET RADIATION IN LITHOGRAPHY AND OTHER APPLICATIONS**
MATERIALIEN, KOMPONENTE UND VERFAHREN ZUR VERWENDUNG MIT EXTREMER UV-STRAHLUNG IN DER LITHOGRAFIE UND ANDEREN ANWENDUNGEN
MATÉRIAUX, COMPOSANT, ET PROCÉDÉS D'UTILISATION AVEC UN RAYONNEMENT ULTRAVIOLET EXTRÊME EN LITHOGRAPHIE ET DANS D'AUTRES APPLICATIONS

(30) Priority: 08.08.2017 US 201762542734 P
(43) Date of publication of application: 17.06.2020
(73) Proprietor: Jaiswal, Supriya, San Diego, CA 92109 (US)
(72) Inventor: Jaiswal, Supriya, San Diego, CA 92109 (US)
(74) Representative: 2SPL Patentanwälte PartG mbB
(86) International application number: PCT/US2018/045878
(87) International publication number: WO 2019/032753

(56) References cited:
- US-A- 5 958 605
- US-A- 5 958 605
- US-A1- 2003 228 529
- US-A1- 2012 225 320
- US-A1- 2013 188 245
- US-A1- 2013 188 248
- US-A1- 2014 168 758
- US-A1- 2016 012 929
- US-A1- 2016 012 929
- US-A1- 2016 147 141
- US-A1- 2017 003 419
- US-B1- 6 188 513
- US-B1- 6 229 652
- US-B1- 6 229 652

## Description

### FIELD OF INVENTION

The field of the invention is the design and fabrication of optical materials, EUV materials, and more particularly reflective materials for wavelength ranges strongly absorbed by many traditional optical materials.

### BACKGROUND

Optical lithography systems are commonly used for fabrication, for example, devices. The resolving power of such systems is proportional to the exposure wavelength. Thus, shorter wavelengths can improve resolution in fabrication. Extreme ultraviolet lithography (EUVL) uses electromagnetic radiation at extreme ultraviolet (EUV) wavelengths (approximately 120 nanometers to 0.1 nanometers). Accordingly, photons at these wavelengths have energies in the range of approximately 10 electron volts (eV) to 12.4 keV (corresponding to 124 nm and 0.1 nm, respectively). Extreme ultraviolet wavelengths may be generated artificially by devices such as plasma and synchrotron light sources. Using EUV wavelengths for lithography has potential advantages of reducing feature sizes in devices such as semiconductor chips as well as in other applications such as polymer electronics, solar cells, biotech, medical technologies.

The documents US 5 958 605 A, US 6 229 652 B1, US 2016/012929 A1, US 2003/228529 A1, US 2013/188245 A1, US 2017/003419 A1, US 2014/168758 A1 and US 2012/225320 A1 describe known optical elements and coatings.

Passive optical elements, such as mirrors, lenses, filters, reflectors, detectors, or collectors are often used in larger light systems. For example, a photolithography system is a microfabrication process that uses light to pattern parts of a thin film or a silicon wafer. It uses light to transfer a geometric pattern from a photomask to a light-sensitive chemical photoresist, or simply resist, on the wafer. This system has a light source that generates light at a target wavelength, and that light is sent through an optical path that has many optical elements before being delivered to the plane of the wafer. In fact, it is not unusual for the light path to have over a dozen mirrors between the light source and the silicon wafer. Presently, many photolithography systems operate at a target wavelength of 193 nm, but to support better resolution and smaller fabrications, even shorter wavelengths will be used. EUV ultraviolet lithography uses light at 13.5 nm. However, most natural materials are highly absorbing at these short wavelengths, resulting in a very inefficient and lossy optical path before light is delivered to the wafer. It is therefore desirable to have new materials or improved materials which are highly responsive and resonant at 13.5 nm, with reflectivity spectral profiles that are both high in amplitude and broad in spectral frequency.

In Lithography a system of mirrors, lenses, filters, films and detectors are used for metrology, transmission, reflection and other components. In a single system the components have a given spectral and angular bandwidth, and mismatch from one component to the next must be minimized or avoided to maximize the transmission through the system. The radiation transmitted through the system or reflected from component to component is called the in-band radiation. Since the lithography system has a light source that is intended to be generated at a specific target frequency, it is important that every optical element in the optical path also be tuned and optimized for that wavelength. If not, the overall system will suffer from very low efficiency, wasting power, damaging optics through out of band radiation and generating heat, and requiring a massive light source. Attaining optimization among many optical elements is extremely difficult, as each element has a peak reflectivity only in a very narrow frequency band. In this way, it is very unlikely that all the optical elements can be constructed such that all the optical elements are reflecting perfectly in that narrow peak band. This mismatch of peak bands among the several optical elements is a major contributor to the overall waste and inefficiency in an optical path.

The selection of reflective materials, or coatings used in elements of lithography are often severely limited. Traditional material combinations consist of a Molybdenum-Silicon (Mo-Si) multilayers which theoretically produce up to 67% reflectivity. Each coating has a reflective spectral curve, and a reflective angular curve. A reflective spectral curve specifies reflectivity as a function of the radiation's wavelength. A reflective angular curve specifies reflectivity as a function of the radiation's angle of incidence (from 0 to 90 degrees, where the first is typically grazing incidence and the latter is normal incidence). Spectral width, or is often characterized as the full width at half bandwidth ("FWHM") bandwidth. The FWHM bandwidth is the spectral range when the reflectivity is 50% of its value. The Mo-Si layer is used on the mirrors, collector and photomasks in EUV lithography systems. Other traditional multilayer combinations include Tungsten and Boron Carbide, Tungsten and Carbon, collectively referred to as the state of the art. Since maximizing peak reflectivity is the primary concern, materials are often selected in combination to produce the highest absolute spectral reflectance. However, if maximizing the peak reflectivity is combined with a narrow spectral bandwidth, then transmitted radiation known as the in-band radiation in a consecutive sequence of components is limited by matching the peak spectral wavelength from component to component, and the bandwidth of the reflected coating. In a reflectivity response or curve it is not just the peak reflectance that matters, but the spectral bandwidth, the average spectral reflectance and total in-band radiation, or the integrated area between the reflectivity curve and the x-axis.

The energy transmitted to the wafer in a lithography system is also limited by the bandwidth of the reflective coating, its total reflective spectral range and energy transmitted by each component. The out-of-band radiation is absorbed by the component and results in adverse heating of the component.

Accordingly, there is a need to improve the bandwidth of a reflective coating at shorter wavelengths in the UV, DUV or EUV wavelengths

### SUMMARY OF THE INVENTION

This disclosure relates generally to materials, devices, apparatus, and methods for use with ultraviolet (UV), deep ultraviolet (DUV), extreme ultraviolet (EUV) and soft X-ray radiation, such as in lithography (EUVL) or other applications. More specifically, but not exclusively, the disclosure relates to materials and components for use in UV, EUV and soft X-ray applications, as well as methods of fabrication and use of such materials and components in apparatus, devices, and systems using EUV radiation

The invention is defined by the features of claim 1. Preferred aspects are defined in the dependent claims.

In certain embodiments, the disclosure relates to an element that can be used in a light exposure system, wherein the system or subsystem includes a light source to transmit light having a wavelength.

In another embodiment, the disclosure relates to an element that can be used in a light exposure system containing a photomask, mirror or lens, substrate element. The system or subsystem can include a light source to transmit light having a wavelength. The element can include a material having plurality of structural features or one or more material combinations.

In another embodiment it relates to coatings used in optical elements and lithography related apparatus and components.

The present invention discloses a novel material for use with an optical element, where the optical element is constructed to operate at a target wavelength in the UV, DUV or EUV bandwidths (0.1 nm to 250 nm). Use of the new material increases the spectral or angular bandwidth of the optical element beyond that of known reflectors at the target bandwidth.

Bandwidth mismatch can be avoided by precisely matching the peak wavelength and/or increasing the spectral bandwidth. Increasing the spectral bandwidth has several advantages. It allows more energy to be carried through entire lithography system and delivered to the wafer. It increases the average spectral reflectance from each spectral curve, and therefore reduces the possibility of bandwidth mismatch from one component to the next. Increasing the bandwidth means than the in-band spectral radiation is increased, and less cooling is required on the optical components, from the out of band radiation.

Increasing the angular bandwidth, allows light incident on the component with larger angles of incidence be transmitted through the system. Larger angles of incidence allow systems with a higher numerical aperture be designed.

This invention relates to material compositions and combinations that increase the spectral and angular bandwidth, and peak performance in a reflectivity or transmission curve beyond larger than that observed by the state of the art reflector. For reference the state of the art reflector is a Molybdenum Silicon (Mo-Si) coating on a fused silica or silicon substrate. From simulation and experiment the bandwidth is the full width half max (FWHM). For Mo-Si the spectral FWHM is 0.63 nm, and the angular bandwidth is +/-10.8 degrees (from normal incidence, 90 degrees). The peak reflectivity is 73% and the useful angular range, where peak reflectivity is maintained above 70% is +/- 6 degrees from normal incidence, also known as the Chief Ray Angle on the Object side, CRAO. The energy transmitted from component to component, or the in-band radiation can be computed as proportional to the normalized integral of the reflectivity (transmission) response curve, hereafter referred to as the integrated energy. The average reflectance is the mean average spectral or angular reflectance across a give set of wavelengths. Angular bandwidth may be increased near the grazing angle or near the normal angle.

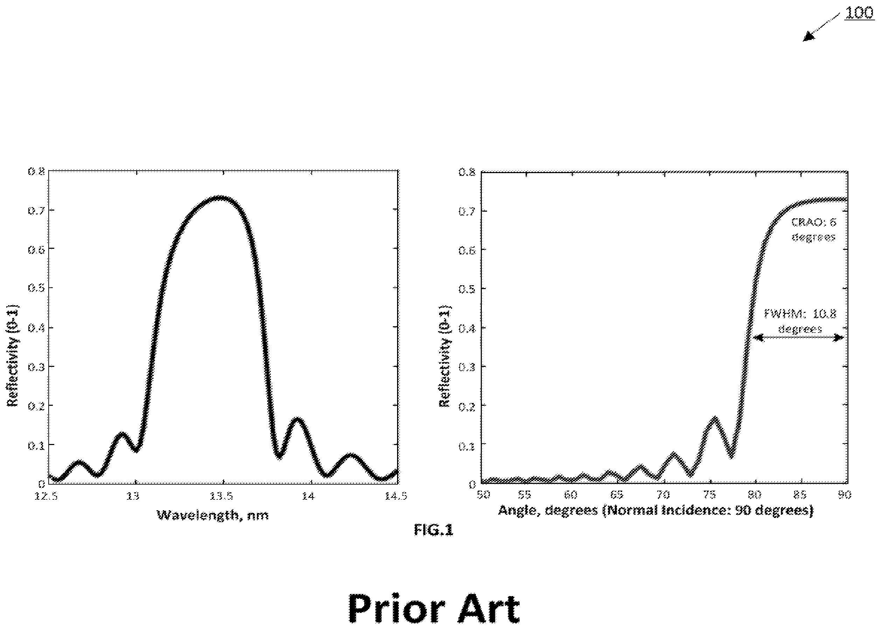

Figure 1 shows the reflectivity response 100 as a function of (a) wavelength (at 90 degrees) and (b) angle (at 13.5 nm) of for a multilayer stack of Mo-Si. The FWHM spectral bandwidth is 0.63 nm. The angular bandwidth is +/- 10.8 degrees. CRAO is +/-6 degrees. The in-band energy transmitted is proportional to 12.70 (arb unit). The average spectral reflectance is 25%. The peak spectral reflectance is 73%.

This invention discloses the use of specific metals, alloys, compounds, mixtures, organic materials and their combinations to tune or increase spectral and angular bandwidth of the reflectivity (transmission) response curve. The invention relates to single films or coatings which may be deposited on substrates, multilayer film combinations (one dimensional coating), or even two and three-dimensional coatings, e.g. coatings which have features or periodicities in two or three dimensions. The coatings may be porous coatings, or ones with high internal surface area, free standing membranes, of films with nanoscale features. The substrates include Si or SiO₂, or sapphire, or glass.

Specifically this invention refers to the combination of metal (M), carbon (C) and H group element (H), where H may be any light element e.g. Helium, Hydrogen, Neon or other gases, or elemental gases, in the periodic table, and used to make materials of the combination MₓC_{y}H_{z}, where x, y, z refer to either mass, volume, ratio, or stoichiometry ratios, and where x>0, y≥0, z>0, and x and y and z can be any number. H group element may be any element with an atomic number lighter than the atomic number of M. For example, a multilayer coating (alternating layers) of MₓC_{y}H_{z} and Si on a silicon substrate can be used to form a highly reflective, broader bandwidth mirror. X, y, or z can be any number, integer or non-integer, and include non stoichiometric combinations.

Typical optical elements and components which make use of such materials include mirrors, filters, lenses, detectors, reflectors, pellicles, substrates, facets, covering layer, capping layer, protective layer, inter diffusion layer, barrier layers, membranes, collectors. These components may be used in lithography systems, printing, scanning, telescopes, inspection tools, light sources, lasers, imaging tools.

Examples of metal (M) include Molybdenum, Niobium, Ruthenium, Zirconium, Technetium, Platinum, Palladium, Gold, Nickel and all metals in rows 4, 5 and 6 of the periodic table.

Examples of H group element include Helium, Hydrogen, Neon or other elemental gases. These can be combined with M and C during deposition of M, and trapped within the coating. Helium is a gas of choice due to its inert non reactive nature, and, light weight and transparency.

In one embodiment co-deposition of the metal in an He environment can lead to incorporation of He in that environment. Similarly co-evaporation of a metal M and a carbon source can also form a mixed or blended material.

In some cases not falling under the scope of protection, the presence of M is not necessary, and pure carbon, or a hydrocarbon may be used instead. This is especially the case of two or three dimensional, materials, i.e. materials which have a plurality of features which for two or three dimensional architecture. In this case x=0. This is also the case for 1D multilayers which use metal free combination materials, or dielectric combination materials for one of the layered materials e.g Si-MₓH_{y}C_{z} where x=0, and y≠0, z≠0.

In other cases the presence of H or C may not be required, in which case y or z may be zero, but not simultaneously, and x will be non zero. For example In the case MoC, x=1, y=0,z=1, and in the case Mo₂C, x=2, y=0, z=1.

In one embodiment x,y,z >1 or y>z>x. In another embodiment, y and z >x. The cases x=0,y=0,z=0 are not considered here. At least one non zero quantity must be present. Similarly the case x=1, y=0,z=0 is also not considered as part of the invention, since many pure metal/dielectric multilayers exist already. This invention specifically refers to cases where H and C, as defined are used in part or whole of the material combination.

Examples of carbon(C) and elements defined by (H), where H is hydrogen include hydrocarbons, carbides, hydrides, carbenes, and any organometallic complex of hydrogen and carbon, or any connection of a metal (M) atom to a Carbon (C) or (H) via a ligand. Similarly, any materials which are used for hydrogen storage, or catalysts for hydrogen storage are also suitable candidates. The combined material may also be a metal organic framework film of M, C and H. It is important that no oxygen is present in the complex.

The presence of C makes the material more robust to high temperatures, and less susceptible to contamination by oxygen, and can be part of a protective layer or capping layer or multilayer.

We make an important distinction between a doped material, a hydrocarbon contaminant and a hydrogen bubble. This invention does not refer to any of those cases. Doping refers to an infusion of impurities into another material, typically in quantities orders of magnitude smaller than the pure material. Doping has minimal effect on reflectivity bandwidth or response amplitude. Hydrocarbon contamination refers to when a hydrocarbon is deposited on a mirror coating, in a random or undesirable place (out of phase). This causes unwanted absorption, or scattering, and therefore a reduction in reflectivity. In the contamination, the hydrocarbon is not properly combined with the metal in the correct ratio or location. It is unintentional and random, and is present by accident rather than deliberating intending to be present in a precise location. Is is not part of a controlled deposition. A hydrogen bubble refers to an undesirable pocket where hydrogen gas has accumulated. This also degrades the reflectivity, as it is not properly combined with the metal, and causes out of phase reflectivity or scattering. Similarly, cases where ambient gases are used to prepare a glass substrate are also not considered, because that does not affect the reflective/transmissive performance or bandwidth of the coating.

Operational activities where the element is bombarded with debris from a plasma source are not included here from the element being used in a lithography tool. Nor is in-situ cleaning with an ambient gas. These are not part of the fabrication process and are subsequent to its development.

Several methods can be used to combine metals with helium, hydrogen and or carbon. Some examples include hydrogenated metals, metal hydrogen complexes, co-evaporation, co sputtering, co deposit, vapor deposition, thermal annealing, and other deposition methods in a vacuum chamber. Examples of hydrocarbons are, e.g. alkanes, alkenes, and alkynes, decane, pentane, pentacene. Other suitable molecules combinations include fullerenes, e.g. C60. For example, the metal may be deposited under ambient gas, buffer gas, or other gases, to form hydrogen enriched, hydrogenated, or hydrogen rich metals. Examples of blended gases or ambient gases include He/Ar, He/N₂, He/H₂, Ne/He H₂/Ar, or N₂/H₂,Ne/Ar, Ne/N₂, Ne/He, Ne/H₂.

Metal organic complexes include for example metallocenes, or benzene/toluene based compounds, or cyclopentadienyl rings, or other complexes, where the atoms or molecules are joined by ligands. Examples of carbon include diamond like carbon, graphene, graphite, double bond carbon, single bond carbon.

MoC and Mo₂C may be used to increase temperature stability, especially in multidimensional architectures, and reduce oxidation, which degrades reflectivity. This may be considered in built the reflective or transmissive coating, and not necessarily in the capping layer or protective layer. Excluded from this invention is a special case of a multilayer of MoC/Si or Mo₂C/Si.

### BRIEF DESCRIPTION OF THE DRAWINGS

The present disclosure may be more fully appreciated in connection with the following detailed description taken in conjunction with the accompanying drawings, wherein:
FIGURE 1 illustrates the reflectivity response as a function of (a) wavelength and (b) angle of a multilayer Mo-Si. The FWHM spectral bandwidth is 0.63 nm.
FIGURE 2 illustrates the reflectivity response as a function of (a) wavelength and (b) angle of a multilayer of MₓH_{y}C_{z}-Si. The FWHM spectral bandwidth is 0.76 nm.
FIGURE 3 illustrates the reflectivity response of a single layer coating deposited on an SiO₂ substrate. The reflectivity response is at 13.5 nm, and measured as a function of angle from grazing (0 degrees) to normal (90 degrees) incidence. In one example, a metal coating (M) is deposited with an angular bandwidth (FWHM) of 25 degrees. In a second example, a coating of MₓH_{y}C_{z}of similar thickness is deposited with an angular bandwidth (FWHM) of 51.3 degrees.
FIGURE 4 shows the architecture of a known multilayer Bragg reflective coating. The architecture consists of a stack of alternative materials, material 1 and material 2 (multilayer) on a substrate, plus a protective layer or capping layer.
FIGURE 5 shows the architecture of a multilayer Bragg reflective coating. The architecture consists of a stack of alternative materials (multilayer) on a substrate, plus a protective layer or capping layer. The stack of materials consists of bilayer pairs of MₓH_{y}C_{z} and silicon, or alternatively M and Si-MₓH_{y}C_{z}.
FIGURE 6 shows a 3D architecture with an MₓH_{y}C_{z} material, which forms a direct part of the coating.

### DETAILED DESCRIPTION OF THE INVENTION

A list of definitions used in this invention is provided below.

| | |
|---|---|
| BiLayers | A pair of layers of from two different materials, e.g. Mo and Si |
| Multilayer | A stack of one or more layers, ranging from 2 layers to greater than 200 layers. |
| Alternating Layers | A sequence of repeating bilayers, multiple layers made from two or more different materials |
| Multilayer Coating | A coating made from a multilayer stack |
| Bragg Reflective Coating | A reflective multilayer stack, containing bilayer pairs, of alternating materials, each layer approximately a quarter wavelength/refractive index in thickness |
| Wavelength range | EUV wavelengths range from 0.1 nm to 100 nm, DUV wavelengths range from 100 nm to 250 nm. Specifically 10-20 nm, and 13.5 nm. |
| No. of Bilayer Pairs | Number of Bilayer pairs ranges from 20 to 40 to 80 or 100 or greater than 100. |
| 3D Architecture | This is a coating, usually formed in a single deposition, and consist of a three dimensional architecture, with structural features or periodicity in two or three dimensions. Unlike a 3D architecture, a multilayer coating is an example of a 1-D architecture. The architecture may contain a plurality structural features including, layers, spheres, cylinders and other such materials. |
| MₓH_{y}C_{z} | x and/or y and/or and/or z can be 0. For x=0, no metal is present, but a hydrocarbon. For the case where z=0, no carbon is present, and MₓH_{y} may be a metal hydride, or a mixture or compound. For the case where y=0, MₓC_{z} , no H is present may be a carbide e.g. Mo₂C. For the case x=0, e.g. a hydrocarbon H_{y}C_{z}. There is no case where x=y=z=0, or x=1, y=z=0. The default assumption is x=1,y=1,x=1 in the case where no subscript is designated. |
| x,y,z | x,y,z represent stoichiometric ratios, but may also represent mixture ratios, of one element relative to the next, or the relative number of atoms of one element to the next. e.g. Ru₂₀He₂₀C₂₀ may represent a mixture of 10 atoms of Ru, 20 atoms of He, and 20 atoms of Carbon, or a relative mixture in that ratio. |
| Combination material | A mixture, alloy, compound or any combination of two or more elements to form a material, in crystalline, amorphous, metallo-organic nature. |
| Ambient Gas | Ambient Gas is the background gas in a vacuum chamber. e.g Argon, N₂, H₂, He, Ne, Kr. These are also referred to as elemental gases. |
| Blended Gas | This is a combination of two or more Ambient Gases |
| Ions | This may be any ions of the ambient gas Argon, N₂, H₂, He, Ne, Kr, or any combination used in sputtering or ion beam deposition |
| Controlled deposition | Intentional and deliberate deposition of any given material with a specific location and quantity to tune or control the optical properties of that material. |
| Sputtering | A process by which a target of a given material is targeted with a beam of ions or atoms of a given species, which generates a plume of the given material, which then deposits uniformly on a substrate forming a film of such material, usually in a vacuum chamber. |
| Reflectivity Curve | A graph show a reflectivity response function or resonance as a function of wavelength/frequency or angle. |
| Transmission Curve | A graph show a transmission response function or resonance as a function of wavelength/frequency or angle. |
| Bandwidth | A spectral or angular range of a reflectivity or transmission curve, bounded by the width of the curve |
| Full Width Half Max (FWHM) | The full bandwidth range at half the peak reflectance of the reflectivity or transmission curve. |
| Integrated Energy | The integrated area under the spectral curve which represents the total energy of the in band radiation |
| Optical Element | An element in a light source system e.g a photolithography tool or an x-ray telescope which interacts with the light. e.g. a mirror. |
| Bandwidth Mismatch | The differences in spectral or angular bandwidth from one optical element to another optical element, making them non-identical. |
| Hydrocarbon | A compound of hydrogen and carbon. |

Optical elements used in photolithography include photomasks, mirrors, detectors, reflectors, spectral purity filters, filters, pellicles, diffraction gratings, polarizers, collectors. Each element may typically contain a substrate e.g. fused silica, silicon, glass, chrome, followed by a reflective or transmissive coating and optionally a protective layer. Each of these elements use similar materials based around a set of pure elements as the basis of their materials, e.g. Molybdenum, Silicon, Niobium, Ruthenium, Technetium, Zirconium, Strontium.

"Metal" refers to elements of the periodic table that are metallic and that can be neutral, or negatively or positively charged as a result of having more or fewer electrons in the valence shell than is present for the neutral metallic element. Metals useful in the present invention include the alkali metals, alkali earth metals, transition metals and post-transition metals. Alkaline earth metals include Be, Mg, Ca, Sr and Ba. Transition metals include Sc, Ti, V, Cr, Mn, Fe, Co, Ni, Cu, Zn, Y, Zr, Nb, Mo, Mg, Tc, Ru, Rh, Pd, Ag, Cd, La, Hf, Ta, W, Re, Os, Ir, Pt, Au, Hg, Al and Ac. Post-transition metals include Al, Ga, In, Tl, Ge, Sn, Pb, Sb, Bi, and Po. Rare earth metals include Sc, Y, La, Ce, Pr, Nd, Sm, Eu, Gd, Tb, Dy, Ho, Er, Tm, Yb and Lu. Alkali metals include Li, Na, K, Rb and Cs. One of skill in the art will appreciate that the metals described above can each adopt several different oxidation states, all of which are useful in the present invention.

### A. Multilayer Coating Embodiment

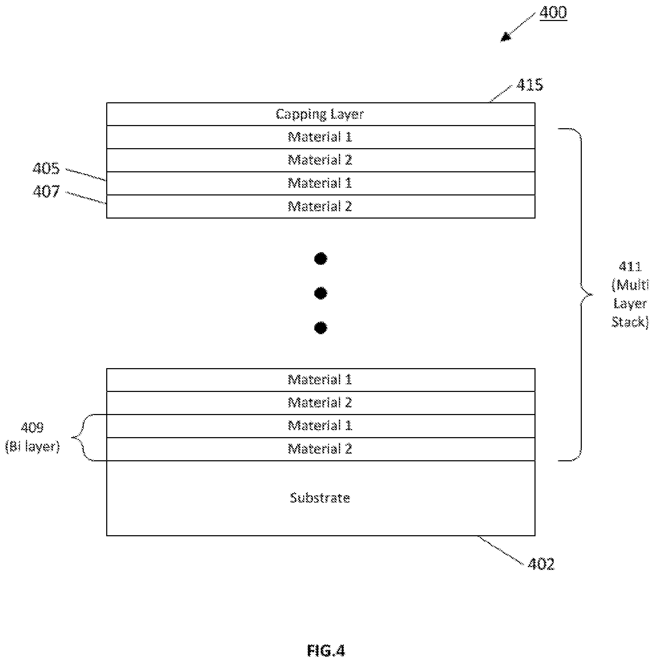

A typical embodiment of a reflective coating is shown in Figure 4. The architecture contains a substrate, topically fused silica, glass, chrome, silicon, quartz, a 1D multilayer Bragg reflective coating e.g. Mo-Si, Nb-Si, W-Si, Ru-Si, or other materials as described in this invention, or as found in US patent application number 15/198,291, which is incorporated by reference.. The multilayer consists of many layers of alternating material, each set of materials forming a bi-layer pair. Optionally on top of the stack of layers or bilayers is a capping layer or protective layer is a coating typically made from Ruthenium or other noble metal.

Figure 4 illustrates a known multilayer reflective optical element 400 having a substrate 402 and a multilayer stack 411 that is constructed with many bi-layer pairs 409. Each bi-layer pair has a first layer of material 1 405, and a second layer of material 2 407. As is well known and common, one of the layers may be Si, and the other layer Mo.

In another embodiment the multilayer coating may be replaced by a 3D architecture, or having a plurality of structural features or one or more material combinations, such as those set out in US patent application number 13/745618. In this case the 3D architecture may be made from a single metal or other material.

In another embodiment e.g. as used in a pellicle, the coating maybe on a membrane, or suspended without a substrate. The coating may consist of a single material, or thin film or porous structure. The material may be Mo or Si or Metal Silicide.

This invention discloses an embodiment that replaces one or more layers in the multilayer reflective coating, the transmissive material used in the pellicle, or the material or the material in the 3D architecture with an MₓH_{y}C_{z} combination material.

The MₓH_{y}C_{z} combination material is made during the fabrication of the coating using a controlled deposition technique where it is deliberately and intentionally distributed in the coating in controlled locations and proportions to uniformly affect the optical properties of the material in those locations. This is distinguished from operational use of the coating, e.g. a mirror placed in front of the plasma source and receives hydrocarbons from debris at the source or in the vacuum chamber and such hydrocarbons or particle defects or ions are randomly positioned in the coating as an adverse effect from operational use of the element.

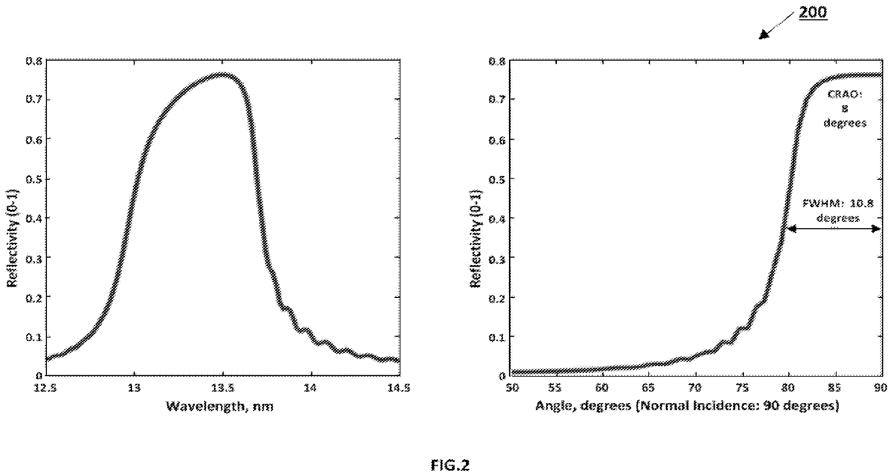

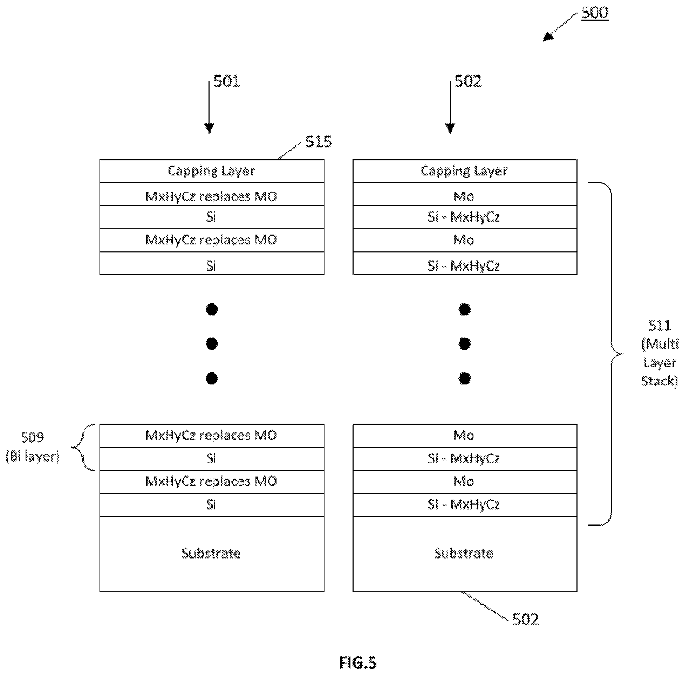

Specifically in the embodiment containing a multilayer architecture the MₓH_{y}C_{z} combination material may replace e.g one or more of the layers of the bilayer pair, or one or more layers of the alternating layers, or one or more layers of the architecture. The net effect is an improved reflectance spectral and or angular curve 200 as shown in Figure 2. The reflectivity response as a function of (a) wavelength and (b) angle of for a multilayer stack of MxCyHz. - Si. The FWHM spectral bandwidth is 0.76 nm. The angular bandwidth is +/- 10.8 degrees. CRAO +/- 8 degrees. The in-band energy transmitted is proportional to 16.14 (arb units). The average spectral reflectance is 31%. The peak spectral reflectance is 76%. Improved reflectance curve includes either increased FWHM, spectral or angular bandwidth increased integrated in band radiation transmitted, less bandwidth mismatch or improved peak amplitude of the curve, as compared to the state of the art Mo-Si. For example in a typical multilayer reflective coating, e.g. Mo-Si, the MₓH_{y}C_{z} combination material may replace Mo, or Si or both e.g . MoH_{y}C_{z} - Si. Figure 5 illustrates the invention in a multilayer (501, 502) architecture 500.

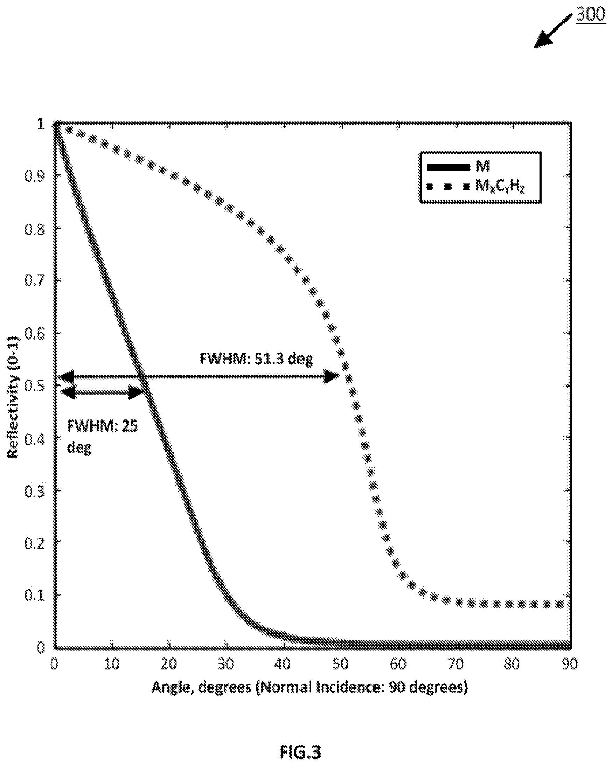

Figure 3 illustrates the reflectivity response 300 of a single layer coating deposited on an SiO₂ substrate. The reflectivity response is at 13.5 nm, and measured as a function of angle from grazing (0 degrees) to normal (90 degrees) incidence. In one example, a metal coating (M) is deposited with an angular bandwidth (FWHM) of 25 degrees. In a second example, a coating of MₓH_{y}C_{z} of similar thickness is deposited with an angular bandwidth (FWHM) of 51.3 degrees. Deposition techniques for these multilayer coatings are sputtering, ion beam deposition, PECVD, Atomic layer deposition, ion assisted deposition, e-beam deposition, chemical vapor deposition, thermal evaporation, ion implantation, molecular beam epitaxy. In the cases of sputtering or ion beam deposition or e-beam deposition charged particles may be used to bombard a target and therefore smoothly, and sometimes uniformly, deposit these layers with absolute control over the MₓH_{y}C_{z} quantities, location and distribution. In one embodiment of the process to deposit the MₓH_{y}C_{z} combination material either Argon, Nitrogen, Helium, Hydrogen, Krypton or Neon ions may be used. Similarly a blended gas containing a combination of two or more of these elements in gas form may also be used.

The process consists of loading two targets of the alternating materials within the chamber, bombarding each of the targets with a combination of two or more of the ions described above, and alternatively depositing thin layers of each of the two materials on to a substrate.

A similar process is used for ion beam deposition, where a second beam or blended ions of one or more ions, the ion assisted deposition beam, may be directed near the substrate to increase the interaction of the plume of target material at the substrate as the film is formed.

Another embodiment of the process consists of co-sputtering or co-evaporating a hybrid material in a deposition chamber. For example, a transition metal may be sputtered at the same time as sputtering or evaporating hydrocarbon within the same vacuum deposition system, in the presence of an ambient or blended gas.

Deposition techniques for the pellicle may additionally include atomic layer deposition, or vapor deposition or electrodeposition or ion implantation. In this case a metal may be conformally deposited, and then post-treated with a hydrocarbon vapor, gas, ambient or blended gas.

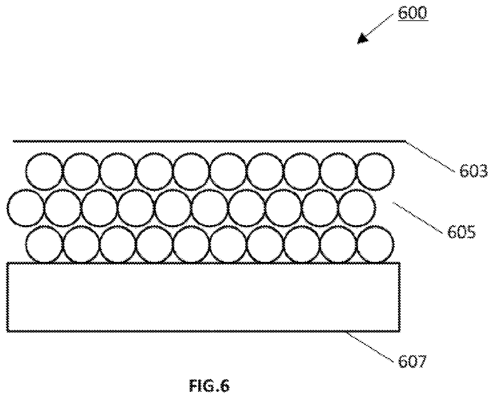

Figure 6 illustrates an optical element 600 having a deposition into a 3 D architecture 605. In this case a metal may be conformally deposited, and then post-treated with a hydrocarbon vapor, gas, ambient or blended gas. The optical element 600 may have an optional capping layer 603, and in some cases may have a substrate 607. In other cases, a substrate may not be required, for example, if the optical element is constructed as part of a membrane structure. Alternatively Figure 6 may be formed by an organometallic complex described herein.

### B. 3D Architecture embodiment

The following architecture may be used on an optical element in a transmissive coating, a membrane, or as part of pellicle. It may also be used in a reflective coating on a mirror or a mask.

2D or 3D architectures are formed from self assembled organic synthetic templates, polymers, organic inorganic hybrids or metallo organic complexes. Such complexes contain Metal (M), Carbon and Hydrogen atoms e.g. for example metallocenes, or benzene/toluene based compounds, or cyclopentadienyl rings, or other complexes, where the atoms or molecules are joined by ligands. Examples of carbon include diamond like carbon, graphene, graphite, double bond carbon, single bond carbon.

Useful 3-dimensional reflective photonic crystals for the present invention are described in U.S. Patent No. 9,322,964. The material can include features that can be used in applications that require operation at one or more electromagnetic wavelength range. In one embodiment, the dimension of structural features is approximately in the same order as the wavelengths used in extreme ultraviolet applications. For example, the structural features can have a dimension of approximately 13.5 nm. In some embodiments, the features can be structural features having dimensions in the order of 10 to 20 nm. In some embodiments, the material can have structural features in the range of 0.001 nm to 10 nm. In some embodiments, the material can have structural features in the range of 10 nm to 250 nm. These features can be referred to as nanoscale features. The nanoscale features can be one dimensional, two dimensional, or three dimensional. The structural features can reduce the bulk electromagnetic absorption of the material. For example, in some applications, the nanoscale features can approximately correlate with the wavelength of the radiation used in that application. The material may include sub-wavelength features.

The nanoscale features can include, for example, a periodic or semi-periodic, quasi-periodic or aperiodic structure or a repeating or repeated element. The periodic structure can be a one, two or three dimensional structure. The structure can be part of a layered structure, or on a substrate. The substrate can be planar. Examples of a periodic structure include a 2D or 3D array of nanoparticles, a gyroidal structure, spheres, cylinders, segments, a swiss-roll structure. The nanoscale features can be of any shape in any dimension, for example, but not limited to, layers, films, spheres, blocks, pyramids, rings, porous structures, cylinders, linked shapes, shells, freeform shapes, chiral structures, hemispheres, segments or any combination thereof.

The material can include, for example, a graded structure. For example a layered structure in any dimension where some layers within the material have lengths, depths, thicknesses, periods or repeating units, that increase or decrease from the previous layer. In one embodiment if the layers are arranged in such a way to produce a graded refractive index, then a customized optical response is produced for a broader range of wavelengths or angles. The structure can be part of a layered structure, or on a substrate.

The material can also include a polymer. The material may further comprise micro or nano structural features of the polymer. The polymer may also be a sacrificial material, or a soft templating or scaffolding structure. The polymer may be self assembled in two or three dimensions.

The polymer structure may be complexed with an organometallic complex using MₓH_{y}C_{z} combination material and then assembled to form a 2D or 3D architecture.

### C. Examples

Figure 5 illustrates a Bragg reflector 500 in accordance with the present invention. Figure 5 shows two example embodiments. In one embodiment 501, a multilayer stack 511 is deposited on a substrate 502. In example 501, each bi-layer pair 509 has a layer of Si and a layer of the MₓH_{y}C_{z} material. A capping layer 515 may be formed to protect the top bi-layer pair. In example 2 502, each bi-layer pair 509 has a layer of Mo and a layer of the MₓH_{y}C_{z} material. A capping layer 515 may be formed to protect the top bi-layer pair. In yet another example (not illustrated) the bi-layer pairs could have a first layer of the MₓH_{y}C_{z} material, and the second layer could be a different the MₓH_{y}C_{z} material having a ratio different than what is used for layer 1.

Figure 6 illustrates a 3D architecture coating, self assembled to a given 3D structure with a single coating formed from a MₓC_{y}H_{z} material.

### D. Uses of Coatings

This invention includes use of the coating in apparatus related to lithography, imaging and printing systems and equipment, and their components and elements therein. This includes lightsources, scanner tools, inspection tools, metrology, and fabrication tools.

While the above detailed description has shown, described, and pointed out novel features as applied to various embodiments, it will be understood that various omissions, substitutions, and changes in the form and details of the devices or algorithms illustrated can be made without departing from the spirit of the disclosure. Thus, nothing in the foregoing description is intended to imply that any particular feature, characteristic, step, module, or block is necessary or indispensable. As will be recognized, the processes described herein can be embodied within a form that does not provide all of the features and benefits set forth herein, as some features can be used or practiced separately from others. The scope of protection is defined by the appended claims rather than by the foregoing description.

## Claims

1. A multilayer Bragg reflective coating (411, 511) for an optical element (400,500), the optical element for use in an optical system operating a target wavelength in the UV, DUV, or EUV bandwidths, the coating comprising:
a substrate (402, 502);
repeating sets of bi-layer pairs (409, 509) forming a multilayer stack (411, 511); each bi-layer pair (409, 509) further comprising:
a first layer (405 ); and
a layer (407) formed with Carbon, an H-group element, and a Metal, wherein Carbon is optional, and in the ratio MₓC_{y}H_{z},
wherein C represents Carbon, H represents the H-group element, and M represents the Metal, wherein
the H-group element is Helium, Hydrogen, Neon or an atom from an elemental gas;
a protective or capping layer (415, 515); and
wherein x > 0, y ≥ 0, and z > 0.

2. The coating (411, 511) according to claim 1, wherein the metal (M) is a metal selected from row 4, 5, or 6 from the periodic table of elements, or is any of the following, Molybdenum, Niobium, Ruthenium, Zirconium, Technetium, Platinum, Palladium, Gold or Nickel.

3. The coating (411,511) according to claim 1, wherein the carbon (C) and the H-group element (H) are hydrocarbons, carbides, hydrides, carbenes, or an organometallic complex of hydrogen and carbon.

4. The coating according to claim 1, wherein the optical element is a photomask, mirror, lens, filter, covering layer, capping layer, substrate, film, pellicle, reflector, detector, or collector, or useable in a light source.

## Patentansprüche

1. Mehrschichtige Bragg-Reflexionsbeschichtung (411, 511) für ein optisches Element (400, 500), wobei das optische Element zur Verwendung in einem optischen System ist, das eine Zielwellenlänge in den UV-, DUV- oder EUV-Bandbreiten betreibt, wobei die Beschichtung umfasst:
ein Substrat (402, 502);
sich wiederholende Sätze von Doppelschichtpaaren (409, 509), die einen Mehrschichtstapel (411, 511) bilden; wobei jedes Doppelschichtpaar (409, 509) ferner umfasst:
eine erste Schicht (405); und
eine Schicht (407), gebildet mit Kohlenstoff, einem H-Gruppe-Element und einem Metall, wobei Kohlenstoff optional ist, und im Verhältnis MₓC_{y}H_{z}, wobei C Kohlenstoff darstellt, H das H-Gruppe-Element darstellt und M das Metall darstellt, wobei das H-Gruppe-Element Helium, Wasserstoff, Neon oder ein Atom aus einem elementaren Gas ist;
eine Schutz- oder Abdeckschicht (415, 515); und
wobei x > 0, y ≥ 0 und z > 0.

2. Die Beschichtung (411, 511) gemäß Anspruch 1, wobei das Metall (M) ein Metall ist, das aus der Reihe 4, 5 oder 6 des Periodensystems der Elemente ausgewählt ist, oder eines der Folgenden ist: Molybdän, Niob, Ruthenium, Zirkonium, Technetium, Platin, Palladium, Gold oder Nickel.

3. Die Beschichtung (411, 511) gemäß Anspruch 1, wobei der Kohlenstoff (C) und das H-Gruppe-Element (H) Kohlenwasserstoffe, Carbide, Hydride, Carbene oder ein organometallischer Komplex aus Wasserstoff und Kohlenstoff sind.

4. Die Beschichtung gemäß Anspruch 1, wobei das optische Element eine Fotomaske, ein Spiegel, eine Linse, ein Filter, eine Deckschicht, eine Abdeckschicht, ein Substrat, ein Film, ein Pellikel, ein Reflektor, ein Detektor oder ein Kollektor ist oder in einer Lichtquelle verwendbar ist.

## Revendications

1. Revêtement réfléchissant de Bragg multicouche (411, 511) pour un élément optique (400, 500), l'élément optique étant destiné à être utilisé dans un système optique faisant fonctionner une longueur d'onde cible dans les largeurs de bande UV, DUV ou EUV, le revêtement comprenant :
un substrat (402, 502) ;
des ensembles répétitifs de paires de bicouches (409, 509) formant un empilement multicouche (411, 511) ; chaque paire de bicouches (409, 509) comprenant en outre :
une première couche (405) ; et
une couche (407) formée avec du carbone, un élément du groupe H, et un métal, le carbone étant facultatif, et dans le rapport MₓC_{y}H_{z}, C représentant le carbone, H représentant l'élément du groupe H, et M représentant le métal, l'élément du groupe H étant l'hélium, l'hydrogène, le néon ou un atome d'un gaz élémentaire ;
une couche de protection ou de recouvrement (415, 515) ; et
dans lequel x > 0, y ≥ 0, et z > 0.

2. Revêtement (411, 511) selon la revendication 1, dans lequel le métal (M) est un métal choisi dans la ligne 4, 5 ou 6 du tableau périodique des éléments, ou est l'un des suivants : molybdène, niobium, ruthénium, zirconium, technétium, platine, palladium, or ou nickel.

3. Revêtement (411, 511) selon la revendication 1, dans lequel le carbone (C) et l'élément du groupe H (H) sont des hydrocarbures, des carbures, des hydrures, des carbènes, ou un complexe organométallique d'hydrogène et de carbone.

4. Revêtement selon la revendication 1, dans lequel l'élément optique est un photomasque, un miroir, une lentille, un filtre, une couche de couverture, une couche de recouvrement, un substrat, un film, une pellicule, un réflecteur, un détecteur, ou un collecteur, ou utilisable dans une source de lumière.
